# EUROPÄISCHE PATENTSCHRIFT

(11) **EP 3 861 573 B1**
(45) Veröffentlichungstag und Bekanntmachung des Hinweises auf die Patenterteilung: **23.11.2022**
(21) Anmeldenummer: 19778874.8
(22) Anmeldetag: 18.09.2019
(51) Int. Cl.: H01L 39/16

(54) **SUPRALEITENDE STROMBEGRENZEREINRICHTUNG MIT STROMZUFÜHRUNG**
SUPERCONDUCTING CURRENT LIMITER DEVICE HAVING POWER FEED
LIMITEUR DE COURANT SUPRACONDUCTEUR COMPRENANT UNE ALIMENTATION EN COURANT

(30) Priorität: 02.10.2018 DE 102018216902
(43) Veröffentlichungstag der Anmeldung: 11.08.2021
(73) Patentinhaber: Siemens Energy Global GmbH & Co. KG, 81739 München (DE)
(72) Erfinder: BAUER, Anne, 90768 Fürth (DE); FRANK, Michael, 91080 Uttenreuth (DE); KRÄMER, Hans-Peter, 91058 Erlangen (DE); KUMMETH, Peter, 91074 Herzogenaurach (DE); WOHLFART, Manfred, 91369 Wiesenthau (DE); VAN HASSELT, Peter, 91058 Erlangen (DE)
(86) Internationale Anmeldenummer: PCT/EP2019/074923
(87) Internationale Veröffentlichungsnummer: WO 2020/069861

(56) Entgegenhaltungen:
- EP-A1- 1 217 666
- WO-A1-2015/193163
- NOE ET AL: "SUPRALEITENDE STROMBEGRENZER IN DER ENERGIETECHNIK", ELEKTRIE, VEB VERLAG TECHNIK. BERLIN, DD, Bd. 51, Nr. 11/12, 1. Januar 1997 (1997-01-01), Seiten 414-424, XP000869316, ISSN: 0013-5399

## Beschreibung

Die vorliegende Erfindung betrifft eine Strombegrenzereinrichtung mit einem supraleitenden Spulenelement, einem Kryostaten, innerhalb dessen das supraleitende Spulenelement angeordnet ist, und wenigstens einer Stromzuführung zur Verbindung des supraleitenden Spulenelements mit einem äußeren Stromkreis.

Aus dem Stand der Technik sind supraleitende Strombegrenzereinrichtungen bekannt, welche typischerweise ein oder mehrere supraleitende Spulenelemente aufweisen, die in einem Kryostaten auf eine kryogene Betriebstemperatur unterhalb der Sprungtemperatur des verwendeten Supraleitermaterials gekühlt werden. Diese Kryostaten isolieren also das tiefkalte Spulenelement von der vergleichsweise warmen äußeren Umgebung. Beispielsweise kann ein solcher Kryostat als Badkryostat ausgelegt sein, welcher im Betrieb mit einem flüssigen kryogenen Kühlmittel gekühlt ist. Häufig handelt es sich bei dem Kühlmittel um flüssigen Stickstoff. Das supraleitende Spulenelement ist dann typischerweise so innerhalb des Kryostaten angeordnet, dass es von dem kryogenen Kühlmittel umspült wird und so direkt von diesem gekühlt werden kann. Um das Kühlmittel und somit indirekt das Spulenelement beim Betrieb dauerhaft kalt zu halten, wird häufig ein Kaltkopf eingesetzt. Ein solcher Kaltkopf kann im Bereich der Außenwand des Kryostaten angeordnet sein und er kann dazu dienen, dass beim Betrieb der Strombegrenzereinrichtung verdampfende Kühlmittel wieder zu kondensieren. Der Kaltkopf kann beispielsweise wiederum durch einen außenliegenden Kompressorkreislauf auf die benötigte kryogene Temperatur gekühlt werden. Die hierbei benötigte Kälteleistung trägt nicht unerheblich zum Energieverbrauch einer solchen Strombegrenzereinrichtung bei. Dies liegt vor allem daran, dass eine vorgegebene Kälteleistung im kryogenen Bereich der Einrichtung nur durch eine wesentlich höhere Leistung (insbesondere u.a. die Kompressorleistung) im warmen Teil der Einrichtung erreicht werden kann. Der Faktor zwischen der für die Kühlung aufgewendeten Leistung und der erreichten Kälteleistung kann beispielsweise bei etwa 25 liegen: In einem solchen Fall muss dann 1 W erreichte Kälteleistung durch den Einsatz von 25 W aufgewendeter Leistung im warmen Bereich der Einrichtung "erkauft" werden. In ungünstigen Fällen kann dieser Faktor sogar noch wesentlich höher sein, beispielsweise sogar bei etwa 100. Ein Beispiel vom Stand der Technik, findet sich in der Patentschrift WO2015/193163.

Nachteilig bei den bekannten Strombegrenzereinrichtungen ist, dass durch elektrische Verluste in den Stromzuführungen ein relativ hoher Bedarf an Kühlleistung entsteht. Die Stromzuführungen werden benötigt, um das supraleitende Spulenelement der Strombegrenzereinrichtung mit einem äußeren Stromkreis zu verbinden. Hierzu müssen insbesondere elektrische Verbindungen zwischen dem kryogenen Bereich der Einrichtung und der warmen äußeren Umgebung vorgesehen werden. Typische resistive Strombegrenzereinrichtungen sind für vergleichsweise hohe Nennströme im Bereich von einigen 100 A oder sogar mehreren kA ausgelegt. Um dem supraleitenden Spulenelement derart hohe Ströme zuführen zu können, sind die Stromzuführungen typischerweise als Kupferleiter mit vergleichsweise hohem Querschnitt realisiert. Durch die hohen Ströme und den ohmschen Widerstand der Kupferleiter wird dabei in den Stromzuführungen beim Betrieb vergleichsweise viel Wärme freigesetzt. Durch den oben beschriebenen ungünstigen Faktor muss dabei permanent eine entsprechende hohe Leistung für den Abtransport dieser Wärme bereitgestellt werden. Dies führt nicht nur zu einem hohen Energiebedarf und hohen Betriebskosten, sondern erhöht auch den apparativen Aufwand bei der Dimensionierung des Kühlsystems (also beispielsweise des Kaltkopfes und des äußeren Kompressors).

Aufgabe der Erfindung ist es daher, eine Strombegrenzereinrichtung anzugeben, welche die genannten Nachteile überwindet. Insbesondere soll eine Strombegrenzereinrichtung zur Verfügung gestellt werden, bei welcher die thermischen Verluste durch den Stromtransport in der Stromzuführung im Vergleich zum Stand der Technik reduziert sind.

Diese Aufgaben werden durch die in Anspruch 1 beschriebene Strombegrenzereinrichtung gelöst. Die erfindungsgemäße Strombegrenzereinrichtung weist ein supraleitendes Spulenelement und einen Kryostaten auf, innerhalb dessen das supraleitende Spulenelement angeordnet ist. Weiterhin weist sie wenigstens eine Stromzuführung zur Verbindung des supraleitenden Spulenelements mit einem äußeren Stromkreis und wenigstens eine Durchführung durch eine Außenwand des Kryostaten auf, durch welche die Stromzuführung geführt ist. Die Stromzuführung umfasst zumindest einen ersten Leitungsteil, der sich zwischen der Durchführung und dem supraleitenden Spulenelement erstreckt, wobei dieser erste Leitungsteil zumindest ein erstes Leiterelement und ein zweites Leiterelement aufweist. Dabei ist das erste Leiterelement als normalleitendes metallisches Leiterelement ausgebildet, und das zweite Leiterelement ist als zu dem ersten Leiterelement parallelgeschaltetes supraleitendes Leiterelement ausgebildet.

Unter der Formulierung, dass sich der erste Leitungsteil zwischen der Durchführung und dem Spulenelement erstreckt, soll verstanden werden, dass zumindest ein Teil der Strecke zwischen Durchführung und Spulenelement elektrisch durch den ersten Leitungsteil überbrückt wird. Es ist jedoch nicht zwingend notwendig, dass die ganze Strecke durch den ersten Leitungsteil überbrückt wird, sondern es können optional auf dieser Strecke auch noch ein oder mehrere dem ersten Leitungsteil in Serie geschaltete weitere Leitungsteile vorliegen und dabei weitere Teilstrecken der genannten Strecke elektrisch überbrücken.

Das wesentliche Merkmal der erfindungsgemäßen Strombegrenzereinrichtung ist also, dass zumindest auf einem Teil der Strecke zwischen Durchführung und Spulenelement die Stromzuführung durch eine Parallelschaltung zwischen einem normalleitenden metallischen Leiterelement und einem supraleitenden Leiterelement gebildet wird. Der wesentliche Vorteil hiervon im Vergleich zu einer rein normalleitenden Stromzuführung liegt darin, dass zumindest im Bereich des beschriebenen ersten Leitungsteils die thermischen Verluste beim Stromfluss durch die Stromzuführung reduziert sind. Diese Reduktion wird dadurch erreicht, dass innerhalb des ersten Leitungsteils der Stromfluss zumindest anteilig durch das parallelgeschaltete supraleitende Leiterelement übernommen wird. Wie hoch der von dem supraleitenden Leiterelement übernommene Anteil ist, hängt von der genauen Ausgestaltung des ersten Leitungsteils ab: unter anderem von dem Verhältnis der Querschnitte zwischen erstem und zweitem Leiterelement, von dem gewählten Supraleitermaterial und insbesondere von der Betriebstemperatur und einem typischerweise vorhandenen Temperaturgradienten über die Länge der Stromzuführung. So ist es beispielsweise möglich, dass das zweite, also das supraleitende Leiterelement nicht auf seiner ganzen Länge auf einer ausreichend niedrigen Betriebstemperatur vorliegt, welche unterhalb der Sprungtemperatur des verwendeten Supraleitermaterials liegt. Zumindest auf einem Teil der Gesamtlänge wird jedoch die Sprungtemperatur unterschritten, denn zumindest das dem Spulenelement zugewandte Ende der Stromzuführung soll sich auf einer ausreichend niedrigen kryogenen Betriebstemperatur befinden. Wesentlich für die Erfindung ist also, dass zumindest in diesem spulenseitigen Bereich der Stromzuführung ein deutlicher Anteil des Betriebsstromes durch das supraleitende Leiterelement im ersten Leitungsteil der Stromzuführung übernommen werden kann. Da zumindest dieser Stromanteil in dem Supraleitermaterial annähernd verlustfrei fließt, sind die für diesen Stromanteil anfallenden thermischen Verluste vernachlässigbar. Es folgt also, dass im Vergleich zu einer rein normalleitenden Stromzuführung die thermischen Verluste und somit auch die insgesamt beim Betrieb benötigte Kälteleistung vorteilhaft reduziert sind.

Der beschriebene Vorteil wird selbst dann realisiert, wenn die Stromzuführung nicht auf ihrer ganzen Länge ein supraleitendes Leiterelement aufweist. Er wird auch dann realisiert, wenn das vorhandene supraleitende Leiterelement nicht auf seiner ganzen Länge im supraleitenden Zustand ist (also bei einer Betriebstemperatur unterhalb der Sprungtemperatur ist). Ferner wird der beschriebene Vorteil auch dann realisiert, wenn der unterhalb der Sprungtemperatur betriebene Bereich des supraleitenden Leiterelements eine kritische Stromdichte aufweist, welche zu niedrig ist, um bei dem gegebenen Supraleiterquerschnitt den gesamten Betriebsstrom verlustfrei transportieren zu können. Selbst bei all den genannten Einschränkungen wird nämlich trotzdem eine anteilige Übernahme des Stromflusses im supraleitenden Leiterelement und somit eine anteilige Reduktion der thermischen Verluste der Stromzuführung realisiert.

Vorteilhafte Ausgestaltungen und Weiterbildungen der Erfindung gehen aus den von Anspruch 1 abhängigen Ansprüchen sowie der folgenden Beschreibung hervor.

Gemäß einer vorteilhaften Ausführungsform weist die Stromzuführung einen zusätzlichen zweiten Leitungsteil auf, welcher normalleitend ist und welcher elektrisch in Serie mit dem ersten Leitungsteil geschaltet ist. Mit anderen Worten ist hierbei die Stromzuführung nicht auf ihrer gesamten Länge, sondern nur auf einem Teil ihrer Länge mit einem supraleitenden Leiterelement ausgestattet. Beispielsweise und besonders zweckmäßig kann der normalleitende Leitungsteil der Stromzuführung an dem vom supraleitenden Spulenelement abgewandten Ende der Stromzuführung angeordnet sein, denn dies ist typischerweise das vergleichsweise warme Ende der Stromzuführung, in dem keine ausreichend niedrige Betriebstemperatur für ein supraleitendes Leiterelement vorliegt. Beispielsweise kann sich der normalleitende zweite Leitungsteil durch die Durchführung in der Außenwand des Kryostaten erstrecken, denn in diesem Bereich liegt typischerweise keine kryogene Betriebstemperatur mehr vor. Optional kann sich der zweite Leitungsteil zusätzlich auch noch in einem Teilbereich innerhalb des Kryostaten erstrecken. Er kann dann also beispielsweise einen Teil der Strecke zwischen Durchführung und Spulenelement überbrücken. Diese Ausführungsform ist dann zweckmäßig, wenn auch in einem solchen Teilbereich die Stromzuführung auf einer Temperatur liegt, welche noch oberhalb der Betriebstemperatur des verwendeten Supraleiters Materials ist. Dies kann beispielsweise innerhalb eines Badkryostaten der Bereich sein, der geodätisch oberhalb des Flüssigkeitspegels eines flüssigen kryogenen Kühlmittels liegt. Dieses Volumen kann beispielsweise durch verdampftes Kühlmittel ausgefüllt sein, welches sich auf einer höheren Temperatur befindet als das unterhalb des Flüssigkeitspegels liegende kondensierte Kühlmittel.

Bei Vorliegen eines solchen rein normalleitenden zweiten Leitungsteils ist es nicht unbedingt erforderlich, dass dieser zweite Leitungsteil als separates Element ausgebildet ist: vielmehr ist es möglich und unter Umständen vorteilhaft, wenn der beschriebene normalleitende zweite Leitungsteil einstückig mit dem normalleitenden ersten Leitungselement des ersten Leitungsteils ausgebildet ist. So kann beispielsweise ein Kupferstab auf einem Teil seiner Länge den rein normalleitenden zweiten Leitungsteil ausbilden (typischerweise am warmen Ende der Stromzuführung) und auf einem anderen Teil seiner Länge das normalleitende Leiterelement des ersten Leitungsteils ausbilden (typischerweise am kalten Ende der Stromzuführung). Nur in diesem kälteren Bereich liegt dann zusätzlich noch wenigstens ein dazu parallelgeschaltetes supraleitendes Leiterelement vor.

Allgemein vorteilhaft kann sich der erste Leitungsteil über einen überwiegenden Teil der Weglänge zwischen der Durchführung und dem supraleitenden Spulenelement erstrecken. In den Fällen, bei denen ein in Serie geschalteter rein normalleitender zweiter Leitungsteil vorliegt, kann also der erste Leitungsteil vorteilhaft zumindest den überwiegenden Anteil der genannten Strecke überbrücken. Dies bewirkt den Vorteil, dass hierbei eine deutliche Reduktion der thermischen Verluste bewirkt werden kann, weil auf einer signifikanten Länge der Stromzuführung zumindest ein Teil des Stroms im supraleitenden Leiterelement transportiert werden kann. Bei Ausführungsformen mit einem Badkryostaten ist es besonders zweckmäßig, wenn zumindest der unterhalb des Flüssigkeitspegels liegende Teil der Stromzuführung durch den beschriebenen ersten Leitungsteil realisiert ist.

Allgemein vorteilhaft können innerhalb des ersten Leitungsteils das erste Leiterelement und das zweite Leiterelement flächig miteinander verbunden sein. Unter einer solchen flächigen Verbindung soll insbesondere eine flächig elektrisch leitfähige Verbindung verstanden werden, welche die beiden parallel geschalteten Leiterelemente nicht nur punktuell, sondern auf ihrer gesamten Länge verbindet. Ein wesentlicher Vorteil dieser Ausführungsform ist, dass durch die flächige Verbindung eine kontinuierliche und für jede Position optimale Aufteilung der Stromanteile zwischen dem normalleitenden ersten Leiterelement und dem supraleitenden zweiten Leiterelement ermöglicht wird. Wenn beispielsweise die Temperatur des ersten Leitungsteils über die Länge variiert, können zum kalten Ende hinzunehmend größere Anteile des Stromtransports von dem supraleitenden Leiterelement übernommen werden. Die flächige elektrische Verbindung bewirkt, dass sich in jedem Teilbereich dieser Länge der zu transportierende Strom optimal zwischen dem normalleitenden Leiterelement und dem supraleitenden Leiterelement aufteilen kann. Hierdurch werden die thermischen Verluste möglichst weitgehend reduziert.

Vorteilhaft kann die flächige elektrische Verbindung so ausgestaltet sein, dass zumindest eines der beiden parallel geschalteten Leiterelemente auf seiner ganzen Breite mit dem anderen Leiterelement verbunden ist. Wenn die Breiten der beiden Leiterelemente unterschiedlich gewählt sind, kann also insbesondere das schmalere Leiterelement auf seiner ganzen Breite mit dem breiteren Leiterelement verbunden sein. Insbesondere können auch mehrere supraleitende Leiterelemente jeweils auf ihrer gesamten Breite mit einem normalleitenden Leiterelement flächig verbunden sein.

Die beschriebene flächige Verbindung zwischen erstem und zweitem Leiterelement kann beispielsweise durch eine Lötverbindung realisiert sein. Durch ein elektrisch leitfähiges Lot kann auf besonders einfache Weise eine elektrisch leitende flächige Verbindung realisiert werden. Alternativ ist es aber auch möglich, eine flächige elektrisch leitende Verbindung beispielsweise mit einem elektrisch leitfähigen Klebemittel zu realisieren. Gemäß einer weiteren Variante können die beiden verbundenen Leiterelemente auch flächig gegeneinander gepresst sein und dabei beispielsweise gegeneinander verschraubt oder geklemmt sein. Bei einer solchen mechanischen Druckverbindung kann der Kontaktbereich zwischen den beiden verbundenen Leiterelementen optional durch eine zusätzliche elektrische Kontaktschicht ausgefüllt sein, beispielsweise durch eine Schicht aus leicht umformbarem und elektrisch leitfähigem Indium.

Allgemein vorteilhaft kann das erste Leiterelement des ersten Leitungsteils aus Kupfer oder einer kupferhaltigen Legierung gebildet sein. Bei der kupferhaltigen Legierung kann es sich insbesondere um Messing handeln. Die genannten Materialien sind besonders vorteilhaft, da sie eine hohe spezifische Leitfähigkeit aufweisen. So kann bei einem vergleichsweise geringen Leiterquerschnitt ein hoher Strom bei vergleichsweise geringen thermischen Verlusten transportiert werden. Alternativ oder zusätzlich kann das erste Leiterelement als Material auch Aluminium aufweisen, da dies ebenfalls eine vergleichsweise hohe spezifische Leitfähigkeit besitzt. Die genannten Materialien sind ebenfalls besonders vorteilhaft als Materialien für den optional vorhandenen in Serie geschalteten zweiten Leitungsteil geeignet.

Allgemein und unabhängig von der genauen Materialwahl ist das erste Leiterelement als Leiterelement mit einer Querschnittsfläche von wenigstens 10 mm² ausgebildet. Eine derart hohe Querschnittsfläche ist zweckmäßig, damit zumindest am warmen Ende des ersten Leitungsteils ein für den Betrieb der Strombegrenzereinrichtung ausreichend hoher Strom in dem normalleitenden Leiterelement transportiert werden kann. Bei hohen Betriebsströmen der Strombegrenzereinrichtung (insbesondere von einigen 100 A bis mehreren kA) ist es vorteilhaft, wenn die Querschnittsfläche des ersten Leiterelements sogar bei wenigstens 50 mm² liegt. Die genannten Werte für die Querschnittsfläche können insbesondere über die gesamte Länge des ersten Leiterelements realisiert sein. Zweckmäßig kann die Querschnittsfläche dabei über die Länge des ersten Leiterelements konstant sein, da dies die Herstellung vereinfacht.

Allgemein und unabhängig von Material und Querschnittsfläche kann das erste Leiterelement beispielsweise als stabförmiges Leiterelement vorliegen. Ein solcher Leiterstab kann beispielsweise entweder massiv oder auch hohl ausgebildet sein. Besonders vorteilhaft ist hier ein Leiterstab mit einem rechteckigen Querschnitt (also insbesondere ein Vierkant-Stab), bei dem ein oder mehrere Hauptflächen des Leiterstabs flächig mit einem supraleitenden Bandleiter verbunden sein können. Das erste Leiterelement kann aber grundsätzlich auch als flexibler bandförmiger Leiter oder auch als Litzenleiter aus einer Vielzahl aus einzelnen miteinander verseilten Teilleitern ausgestaltet sein.

Allgemein vorteilhaft und unabhängig von der genauen Ausgestaltung des ersten Leiterelements kann das zweite Leiterelement einen supraleitenden Bandleiter aufweisen. Ein solcher Bandleiter kann eine supraleitende Schicht auf einem bandförmigen Substrat aufweisen. Ein solcher Bandleiter ist besonders geeignet, um eine flächige elektrisch leitfähige Verbindung zu dem normalleitenden ersten Leiterelement zu realisieren. Außerdem sind heutzutage supraleitende Bandleiter mit einer hohen Leiterqualität und insbesondere einer hohen kritischen Stromdichte bei vergleichsweise hohen Temperaturen allgemein verfügbar.

Gemäß einer allgemein bevorzugten Ausführungsform kann das zweite Leiterelement ein hochtemperatursupraleitendes Material umfassen. Hochtemperatursupraleiter (HTS) sind supraleitende Materialien mit einer Sprungtemperatur oberhalb von 25 K (und bei einigen Materialklassen oberhalb von 77 K), bei denen die Betriebstemperatur durch Kühlung mit anderen kryogenen Materialien als flüssigem Helium erreicht werden kann. HTS-Materialien sind auch deshalb besonders attraktiv, da diese Materialien abhängig von der Wahl der Betriebstemperatur hohe obere kritische Magnetfelder sowie hohe kritische Stromdichten aufweisen können. Besonders vorteilhaft können viele HTS-Materialien mit flüssigem Stickstoff gekühlt werden.

Der Hochtemperatursupraleiter kann einen oxidkeramischen Supraleiter der zweiten Generation, beispielsweise eine Verbindung des Typs REBa₂Cu₃Oₓ (kurz REBCO) aufweisen, wobei RE für ein Element der seltenen Erden oder eine Mischung solcher Elemente steht. Alternativ kann es sich aber auch um einen HTS-Leiter der ersten Generation (1G-HTS) handeln, beispielsweise um eine Verbindung des Typs Bi2223 oder Bi2212. Auch Magnesiumdiborid kommt als vorteilhaftes HTS-Material in Frage.

Allgemein und unabhängig von der Materialwahl kann das zweite Leiterelement mehrere supraleitende Teilleiter und insbesondere mehrere supraleitende Bandleiter aufweisen. Dabei ist es beispielsweise möglich, dass das zweite Leiterelement durch einen Stapel von mehreren supraleitenden Bandleitern gebildet ist. Alternativ oder zusätzlich können auch mehrere supraleitende Bandleiter (beziehungsweise Bandleiterstapel) auf separaten Flächen eines normalleitenden Leiterelements angeordnet sein und zusammen das zweite Leiterelement ausbilden. In jedem Fall ist es vorteilhaft, wenn die Mehrzahl von supraleitenden Teilleitern untereinander elektrisch parallelgeschaltet ist. Die Anzahl von Teilleitern muss dabei nicht zwangsläufig über die Länge des ersten Leitungsteils konstant sein. Beispielsweise kann auch am wärmeren Ende des ersten Leitungsteils (also an dem vom Spulenelement abgewandten Ende) die Anzahl von parallelgeschalteten Teilleitern erhöht sein, um ein Absinken der kritischen Stromdichte mit der höher werdenden Betriebstemperatur zu kompensieren.

Allgemein vorteilhaft kann der Kryostat als Badkryostat ausgebildet sein, wobei er zur Befüllung mit einem flüssigen kryogenen Kühlmittel ausgelegt ist. Geeignete kryogene Kühlmittel sind beispielsweise flüssiger Stickstoff, flüssiges Helium, flüssiges Neon, flüssiger Wasserstoff, flüssiger Sauerstoff und/oder flüssiges Methan. Dabei kann bei Verwendung all dieser kryogenen Kühlmittel prinzipiell die flüssige Form im Gleichgewicht neben der Gasform vorliegen. Insbesondere kann innerhalb des Badkryostaten ein Flüssigkeitspegel (also eine vorgegebene Füllhöhe) vorgesehen sein, bis zu dem im Betrieb das verflüssigte Kühlmittel reicht. Wenn die zu kühlenden Komponenten - wie Spulenelement(e) und Stromzuführung(en) - mit dem flüssigen Kühlmittel gekühlt werden, kommt es dabei typischerweise zu einer anteiligen Verdampfung des Kühlmittels. Dieses verdampfte Kühlmittel wird dann typischerweise durch die übrigen Teile des Kühlsystems (häufig an einem Kaltkopf und/oder einem separaten Kondensor) wieder kondensiert. Zweckmäßig ist der Badkryostat für einen Betrieb bei Überdruck ausgelegt. Er kann beispielsweise auch aus einem Kryostat-Behälter und einem Kryostat-Deckel zusammengesetzt sein.

In jedem Fall ist es bei Einsatz eines Badkryostaten vorteilhaft, wenn der beschriebene erste Leitungsteil (mit parallelgeschaltetem normalleitendem und supraleitendem Leiterelement) zumindest den Teil der Weglänge der Stromzuführung überbrückt, welcher beim Betrieb in das flüssige Kühlmittel eingetaucht ist. Mit anderen Worten erstreckt sich der erste Leitungsteil dann zumindest von dem Spulenelement bis zur vorgesehenen Füllhöhe des Badkryostaten.

Weiterhin kann es vorteilhaft sein, wenn der Badkryostat für eine Füllhöhe ausgelegt ist, die so gewählt ist, dass beim Betrieb der Strombegrenzereinrichtung der erste Leitungsteil zu wenigstens 50 % seiner Länge in das flüssige Kühlmittel eingetaucht ist. Mit anderen Worten soll ein überwiegender Anteil des ersten Leitungsteils beim Betrieb von dem flüssigen Kühlmittel umspült sein, was vorteilhaft eine effiziente Kühlung des supraleitenden Leiterelements und somit auch einen annähernd verlustfreien Transport von zumindest einem Teil des Betriebsstroms erlaubt. Eine derartige Auslegung ist bei Vorliegen von mehreren Stromzuführungen vor allem für diejenige Stromzuführung leicht zu erreichen, mit der ein geodätisch vergleichsweise weiter untenliegender Bereich des Spulenelements kontaktiert wird.

Die Strombegrenzereinrichtung kann zusätzlich vorteilhaft einen Kaltkopf umfassen, der im Bereich einer Außenwand des Kryostaten angeordnet ist. Beispielsweise kann ein solcher Kaltkopf bei einer zweiteiligen Ausführung des Kryostaten vom Kryostat-Deckel gehalten werden. Allgemein zweckmäßig ragt ein solcher Kaltkopf zumindest teilweise in den Innenraum des Kryostaten hinein, sodass der innenliegende Bereich mit dem Kaltkopf gekühlt werden kann. Vorteilhaft befindet sich der Kaltkopf oberhalb des Kühlmittelpegels, sodass das verdampfte Kühlmittel im Bereich des Kaltkopfes kondensieren und somit wieder dem flüssigen Kühlmittelreservoir zugeführt werden kann. Diese Kondensation kann entweder direkt an dem Kaltkopf oder an einem optional zusätzlich vorhandenen Kondensor erfolgen.

Gemäß einer allgemein vorteilhaften Ausführungsform kann die Strombegrenzereinrichtung wenigstens zwei Stromzuführungen umfassen. Das Vorliegen von zwei solchen Stromzuführungen ist zweckmäßig, um das Spulenelement mit einem äußeren geschlossenen Stromkreis verbinden zu können. Besonders vorteilhaft ist dann auch die zweite Stromzuführung so ausgestaltet wie die weiter oben beschriebene wenigstens eine erste Stromzuführung. Zweckmäßig liegt dann auch für jede Stromzuführung eine eigene ihr zugeordnete Durchführung durch die Außenwand des Kryostaten vor.

Nachfolgend wird die Erfindung anhand einiger bevorzugter Ausführungsbeispiele unter Bezugnahme auf die angehängten Zeichnungen beschrieben, in denen:
- Figur 1: eine schematische Querschnittsdarstellung einer Strombegrenzereinrichtung nach einem ersten Beispiel der Erfindung zeigt,
- Figur 2: eine schematische Querschnittsdarstellung einer Strombegrenzereinrichtung nach einem zweiten Beispiel der Erfindung zeigt und
- Figur 3: eine schematische lokale Querschnittsdarstellung für den ersten Leitungsteil einer Stromzuführung zeigt.

In den Figuren sind gleiche oder funktionsgleiche Elemente mit gleichen Bezugszeichen versehen.

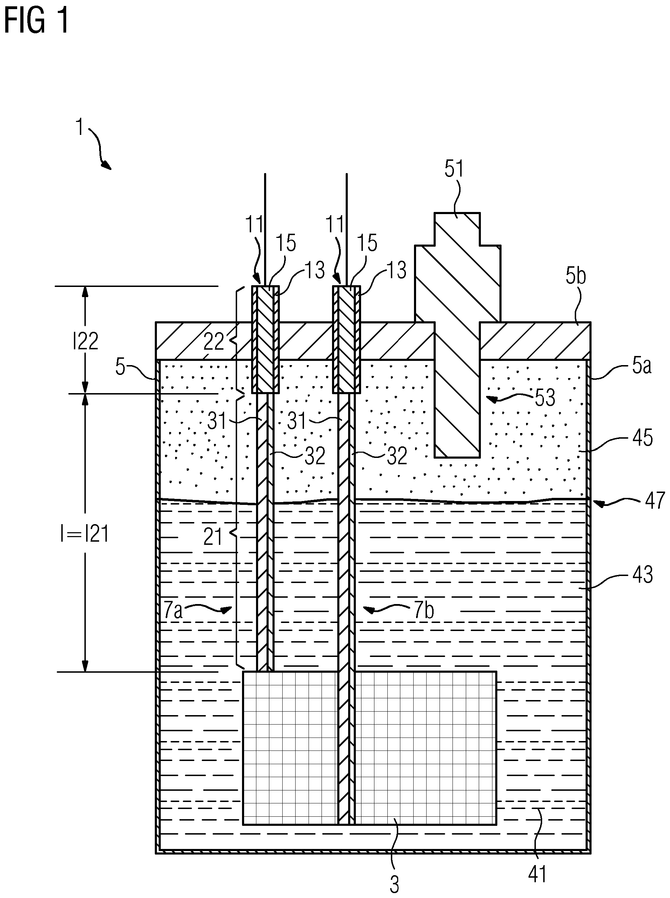

In Figur 1 ist eine schematische Querschnittsdarstellung einer Strombegrenzereinrichtung 1 nach einem ersten Ausführungsbeispiel der Erfindung gezeigt. Es handelt sich hierbei um eine resistive supraleitende Strombegrenzereinrichtung. Sie umfasst ein supraleitendes Spulenelement 3, welches im Innenraum eines Kryostaten 5 angeordnet ist und durch diesen thermisch gegen die äußere Umgebung isoliert ist. Beim Betrieb wird das supraleitende Spulenelement 3 auf eine kryogene Betriebstemperatur unterhalb der Sprungtemperatur des verwendeten Supraleitermaterials gekühlt. Bei dem Spulenelement 3 kann es sich beispielsweise um eine bifilar gewickelte Spule, insbesondere aber auch um einen Stapel aus mehreren solchen senkrecht übereinanderliegenden bifilaren Spulen handeln.

Beim vorliegenden Beispiel ist der Kryostat 5 als Badkryostat ausgelegt, der beim Betrieb der Strombegrenzereinrichtung mit einem flüssigen Kühlmittel 41 befüllt wird. Bei dem flüssigen Kühlmittel kann es sich beispielsweise um verflüssigten Stickstoff handeln. Der Kryostat 5 ist für eine Füllhöhe 47 ausgelegt, wobei sich geodätisch unterhalb dieser Füllhöhe 47 ein Flüssigkeitsraum 43 und oberhalb davon ein Gasraum 45 befindet. Das Spulenelement 3 ist dabei vollständig im Flüssigkeitsraum 43 angeordnet, sodass das Spulenelement von flüssigem Kühlmittel umspült werden kann und direkt durch dieses gekühlt werden kann. Der Kryostat 5 ist aus einem untenliegenden Kryostat-Behälter 5a und einem obenliegenden Kryostat-Deckel 5b zusammengesetzt. In den Kryostat-Deckel 5b ist dabei ein Kaltkopf 51 eingesetzt, der in den Innenraum des Kryostaten hineinragt. Dieser Kaltkopf 51 weist einen Kondensorbereich 53 auf, an dem das bei der Kühlung verdampfte Kühlmittel kondensieren kann und von hier aus dem Flüssigkeitsraum 43 wieder zurückgeführt werden kann. Der Kondensorbereich 53 des Kaltkopfes 51 wird durch hier nicht näher dargestellte weitere Komponenten des Kühlsystems (beispielsweise einen außerhalb des Kryostaten angeordneten Kompressorkreislauf) permanent auf einer kryogenen Temperatur gehalten, die zur Verflüssigung des Kühlmittels geeignet ist.

Um das supraleitende Spulenelement 3 mit einem äußeren Stromkreis verbinden zu können, weist die Strombegrenzereinrichtung 1 zwei Stromzuführungen 7a und 7b auf, welche innerhalb des Kryostaten 5 elektrisch mit dem Spulenelement 3 verbunden sind. Jeder Stromzuführung ist dabei eine Durchführung 11 durch den Kryostat-Deckel 5b zugeordnet, so dass die Stromzuführungen 7a und 7b durch den Kryostaten 5 hindurch nach außen geleitet werden können. Beim gezeigten Beispiel weisen beide Stromzuführungen 7a und 7b die weiter oben beschriebenen erfindungsgemäßen Merkmale auf, sodass für beide die Vorteile der Erfindung realisiert werden können. Die links dargestellte Stromzuführung 7a kontaktiert dabei einen vergleichsweise weiter oben liegenden Bereich des Spulenelements 3, und die rechts dargestellte Stromzuführung 7b kontaktiert dabei einen vergleichsweise weiter unten liegenden Bereich des Spulenelements 3.

Jede der beiden Stromzuführungen 7a und 7b weist einen ersten Leitungsteil 21 und einen zweiten Leitungsteil 22 auf. Dabei ist jeweils der erste Leitungsteil durch eine Parallelschaltung zwischen einem ersten, normalleitenden Leiterelement 31 und einem zweiten, supraleitenden Leiterelement 32 gebildet. Der zu dem ersten Leitungsteil 21 in Serie geschaltete zweite Leitungsteil 22 ist dagegen rein normalleitend ausgeführt. Beim gezeigten Beispiel ist der zweite Leitungsteil 22 jeweils durch den im Bereich der Durchführung 11 innerhalb der Isolation 13 vorliegenden Leiter 15 ausgebildet. Der zweite Leitungsteil 22 weist jeweils eine Länge 122 auf. Der erste Leitungsteil 21 schließt sich jeweils innerhalb des Kryostaten 5 an den normalleitenden Leiter 15 der zugeordneten Durchführung 11 an und überbrückt so die gesamte Weglänge 1 zwischen der Durchführung und dem jeweiligen Anschluss des Spulenelements. Mit anderen Worten entspricht die Länge 121 des ersten Leitungsteils genau dieser innerhalb des Kryostaten 5 zu überbrückenden Weglänge 1. Diese beiden Längen 1 und 121 sind in Figur 1 beispielhaft nur für die links dargestellte Stromzuführung 7a eingezeichnet, welche den obenliegenden Teil des Spulenelements 3 kontaktiert. Für die rechts dargestellte Stromzuführung 7b, die den unteren Teil des Spulenelements 3 kontaktiert, sind diese beiden Längen ebenfalls identisch. Sie sind jedoch insgesamt etwas länger.

Das normalleitende Leiterelement 31 der beiden ersten Leitungsteile 21 ist dabei jeweils durch einen massiven Vierkant-Stab aus Kupfer gebildet. Der Querschnitt dieses Kupferleiters ist dabei ausreichend hoch gewählt, um auch alleine den Betriebsstrom für den Strombegrenzer transportieren zu können. Mit diesen beiden Kupferstäben ist jeweils auf ihrer ganzen Länge wenigstens ein supraleitendes Leiterelement 32 flächig verbunden. Beispielsweise ist bei jedem Kupferstab auf wenigstens einer Außenfläche ein supraleitender Bandleiter flächig mit dem Kupferstab kontaktiert. Diese flächige Kontaktierung kann beispielsweise über eine flächige Lötverbindung realisiert sein. Diese Lötverbindung erstreckt sich beim gezeigten Beispiel über die ganze Länge des jeweiligen Kupferstabs und über die ganze Breite des jeweiligen supraleitenden Bandleiters.

Beim Betrieb der Strombegrenzereinrichtung 1 sind die supraleitenden Leiterelemente 32 nicht zwangsläufig auf ihrer gesamten Länge im supraleitenden Zustand. Beispielsweise kann die Betriebstemperatur des Gasraums 45 so gewählt sein, dass die supraleitenden Leiterelemente 32 hier nicht mehr unterhalb ihrer Sprungtemperatur vorliegen. Es könnte alternativ auch sein, dass zwar die Sprungtemperatur noch unterschritten wird, dass aber innerhalb des Gasraums 45 die erreichbare kritische Stromdichte im Supraleiter relativ niedrig ist, so dass mit dem zur Verfügung stehenden Supraleiter-Querschnitt nicht der ganze benötigte Strom verlustfrei transportiert werden kann. Auf jeden Fall soll aber im Bereich des Flüssigkeitsraums 43 die Sprungtemperatur für die beiden supraleitenden Leiterelemente 32 unterschritten sein. Auf diese Weise wird zumindest unterhalb der Füllhöhe 47 ein supraleitender Zustand und vorteilhaft auch eine vergleichsweise hohe kritische Stromdichte in den supraleitenden Leiterelementen 32 erreicht. Hierdurch wird zumindest unterhalb der Füllhöhe 47 und zumindest für einen Teil des zu transportierenden Stroms ein verlustarmer Stromtransport zwischen den Durchführungen 11 und dem Spulenelement 3 erreicht. Beim gezeigten Beispiel taucht jeweils der überwiegende Teil der Länge 121 des jeweiligen ersten Leitungsteils 21 in den Flüssigkeitsraum 43 ein. Im Vergleich zu einer reinen normalleitenden Ausführung der Stromzuführungen wird hier eine deutliche Reduzierung der thermischen Verluste und somit auch eine Reduzierung der benötigten Kühlleistung der Strombegrenzereinrichtung bewirkt.

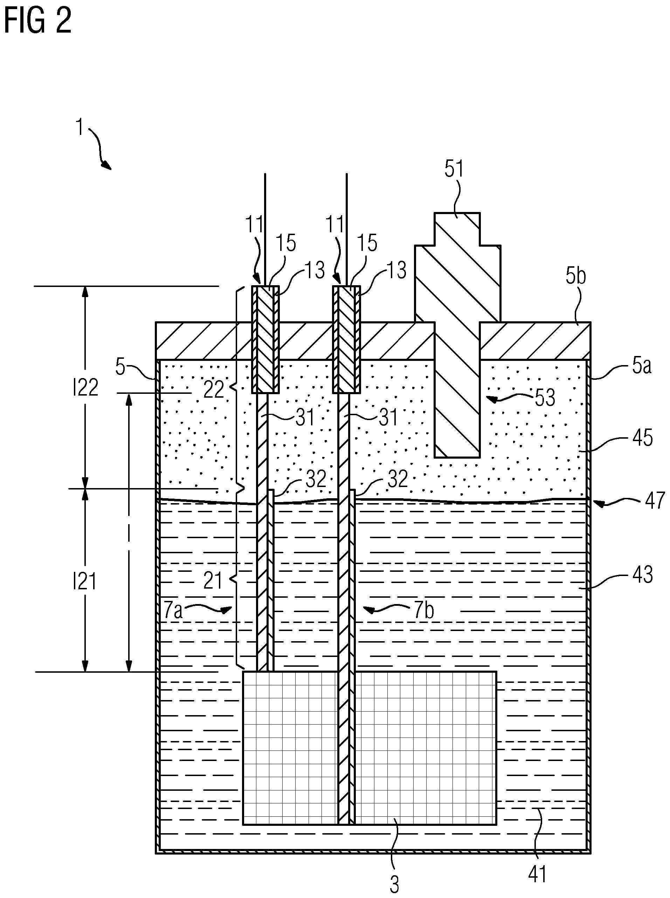

In Figur 2 ist eine schematische Querschnittsdarstellung einer Strombegrenzereinrichtung 1 nach einem zweiten Ausführungsbeispiel der Erfindung gezeigt. Diese Strombegrenzereinrichtung ist im Wesentlichen ähnlich aufgebaut wie die des ersten Ausführungsbeispiels. Der wesentliche Unterschied zum Beispiel der Figur 1 liegt darin, dass die Weglänge 1 zwischen der Durchführung 11 und dem supraleitenden Spulenelement 3 hier nicht vollständig, sondern nur zum Teil durch den beschriebenen ersten Leitungsteil 21 überbrückt wird. Die Länge 121 ist hier also kleiner als die gesamte im Innenraum des Kryostaten zu überbrückende Weglänge l. Der verbleibende Teil der zu überbrückenden Weglänge wird hier durch einen rein normalleitenden Leiter verbunden. Mit anderen Worten liegt also auch hier eine Serienschaltung zwischen einem (wenigstens teilweise supraleitenden) ersten Leitungsteil 21 und einem rein normalleitenden Leitungsteil 22 vor. Der rein normalleitende Leitungsteil 22 bildet hier aber nicht nur den Innenleiter 15 der Durchführung 11, sondern auch einen weiteren normalleitenden Leitungsabschnitt innerhalb des Dampfraums 45 des Kryostaten 5 aus.

Analog wie beim ersten Beispiel sind die ersten Leitungsteile auch hier jeweils durch eine flächig verbundene Parallelschaltung aus einem massiven Kupferstab (als erstes Leiterelement 31) und einem supraleitenden Bandleiter (als zweites Leiterelement 32) gebildet. Diese ersten Leitungsteile 21 tauchen beide zum überwiegenden Teil in den Flüssigkeitsraum 43 des Kryostaten ein. Bei beiden Stromzuführungen 7a und 7b endet jedoch hier jeweils das supraleitende Leiterelement 32 knapp oberhalb des Flüssigkeitspegels 47. Im überwiegenden Teil des Gasraums 45 werden die Stromzuführungen 7a und 7b hier durch die rein normalleitenden Leitungsteile 22 gebildet. Diese zweite Ausführungsvariante ist insbesondere dann vorteilhaft, wenn die Stromzuführungen im Bereich des Gasraums ohnehin keine ausreichend niedrige Betriebstemperatur aufweisen würden, um einen verlustarmen Stromtransport in den Supraleitern zu ermöglichen. So kann in diesem Bereich das supraleitende Leitermaterial eingespart werden. Beim Beispiel der Figur 2 geht das normalleitende Leiterelement 31 des ersten Leitungsteils einstückig in den unteren Bereich des zweiten Leitungsteils 22 über: es handelt sich jeweils um denselben Kupferstab, der aber nur in seinem untenliegenden Teil flächig mit dem zugeordneten supraleitenden Leiterelement 32 verbunden ist und daher nur hier einen Teil des ersten Leitungsteils 21 bildet.

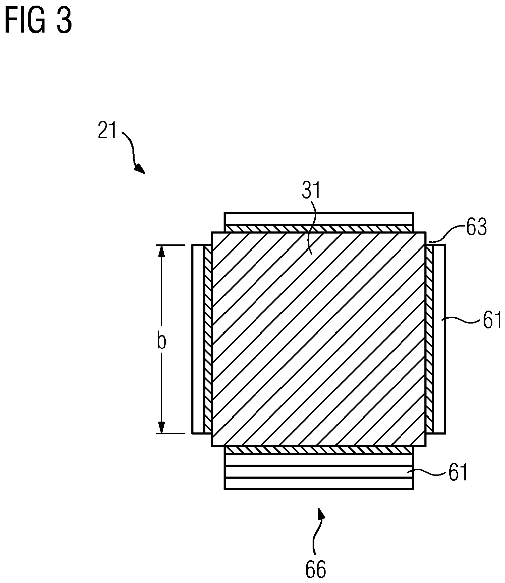

In Figur 3 ist eine schematische lokale Querschnittsdarstellung für einen beispielhaften ersten Leitungsteil 21 einer Stromzuführung gezeigt. Beispielsweise können die ersten Leitungsteile 21 aus den Beispielen der Figuren 1 und 2 auf eine solche oder ähnliche Weise realisiert sein. Auch hier weist der gezeigte erste Leitungsteil 21 eine Parallelschaltung aus einem ersten normalleitenden Leiterelement 31 und einem zweiten supraleitenden Leiterelement auf. Das erste normalleitende Leiterelement 31 ist auch hier als massiver Vierkant-Stab aus Kupfer gebildet. Die vier Außenflächen dieses Vierkant-Stabs sind dabei jeweils flächig mit einem oder mehreren supraleitenden Bandleitern 61 verbunden. Diese flächige elektrisch leitende Verbindung ist dabei jeweils über leitfähige Lotschichten 63 realisiert. Dabei sind die jeweiligen Bandleiter 61 nicht nur auf ihrer gesamten Länge, sondern auch auf ihrer gesamten Breite b flächig mit dem normalleitenden Kupferstab 31 verbunden. Die Mehrzahl von supraleitenden Bandleitern 61 ist elektrisch untereinander parallelgeschaltet und bildet zusammen das supraleitende zweite Leiterelement des ersten Leitungsteils 21 aus. Die Anordnung von Bandleitern auf allen vier Außenflächen des Kupferstabes ist dabei nur beispielhaft zu verstehen. Grundsätzlich reicht es aus, wenn nur ein einzelner supraleitender Leiter mit dem normalleitenden Leiter auf einer Außenfläche flächig verbunden ist. Es können aber auch beispielsweise auf zwei Außenflächen oder auf drei Außenflächen des Kupferstabes supraleitende Leiter angeordnet sein.

In der Figur 3 ist für die untenliegende Außenfläche des Kupferstabes 31 beispielhaft gezeigt, dass anstelle eines einzelnen Bandleiters 61 auch ein Stapel 66 von mehreren Bandleitern vorliegen kann. Die Anordnung eines solchen Stapels ist selbstverständlich auch auf den anderen Außenflächen des normalleitenden Leiterelements 31 möglich und soll nur die Variationsmöglichkeit der Ausgestaltungen verdeutlichen. Wesentlich für die erfindungsgemäße Wirkung ist nur, dass zumindest ein supraleitender Leiter zumindest auf einem Teil der Länge der Stromzuführung mit einem normalleitenden Leiter parallelgeschaltet ist.

### Bezugszeichenliste

- 1: Strombegrenzereinrichtung
- 3: supraleitendes Spulenelement
- 5: Kryostat
- 5a: Kryostat-Behälter
- 5b: Kryostat-Deckel
- 7a: erste Stromzuführung
- 7b: zweite Stromzuführung
- 11: Durchführung
- 13: Isolation
- 15: Leiter der Durchführung
- 21: erster Leitungsteil
- 22: zweiter Leitungsteil
- 31: normalleitendes Leiterelement
- 32: supraleitendes Leiterelement
- 41: Kühlmittel
- 43: Flüssigkeitsraum
- 45: Gasraum
- 47: Füllhöhe
- 51: Kaltkopf
- 53: Kondensorbereich
- 61: supraleitender Bandleiter
- 63: Lotschicht
- 66: Bandleiterstapel
- b: Breite des Bandleiters
- l: Weglänge zwischen Durchführung und Spulenelement
- l21: Länge des ersten Leitungsteils
- l22: Länge des zweiten Leitungsteils

## Patentansprüche

1. Strombegrenzereinrichtung (1) mit
- einem supraleitenden Spulenelement (3),
- einem Kryostaten (5), innerhalb dessen das supraleitende Spulenelement (3) angeordnet ist,
- wenigstens einer Stromzuführung (7a,7b) zur Verbindung des supraleitenden Spulenelements (3) mit einem äußeren Stromkreis
- und wenigstens einer Durchführung (11) durch eine Außenwand des Kryostaten (5), durch welche die Stromzuführung (7a,7b) geführt ist,
- wobei die Stromzuführung (7a,7b) zumindest einen ersten Leitungsteil (21) umfasst, der sich zwischen der Durchführung (11) und dem supraleitenden Spulenelement (3) erstreckt,
- wobei der erste Leitungsteil (21) zumindest ein erstes Leiterelement (31) und ein zweites Leiterelement (32) aufweist,
- wobei das erste Leiterelement (31) als normalleitendes metallisches Leiterelement ausgebildet ist und das zweite Leiterelement (32) als dazu parallelgeschaltetes supraleitendes Leiterelement ausgebildet ist,
- dadurch charakterisiert, dass das erste Leiterelement (31) als Leiterelement mit einer Querschnittsfläche von wenigstens 10 mm² gebildet ist.

2. Strombegrenzereinrichtung (1) nach Anspruch 1, bei welcher die Stromzuführung (7a,7b) einen zusätzlichen zweiten Leitungsteil (22) aufweist, welcher normalleitend ist und welcher elektrisch in Serie mit dem ersten Leitungsteil (21) geschaltet ist.

3. Strombegrenzereinrichtung (1) nach Anspruch 1 oder 2, bei welcher der erste Leitungsteil (21) sich über einen überwiegenden Teil der Weglänge (l) zwischen der Durchführung (11) und dem supraleitenden Spulenelement (3) erstreckt.

4. Strombegrenzereinrichtung (1) nach einem der vorhergehenden Ansprüche, bei welcher innerhalb des ersten Leitungsteils (21) das erste Leiterelement (31) und das zweite Leiterelement (32) flächig miteinander verbunden sind.

5. Strombegrenzereinrichtung (1) nach Anspruch 4, bei der sich die flächige Verbindung zwischen dem ersten Leiterelement (31) und dem zweiten Leiterelement (32) über die gesamte Länge (l21) des ersten Leitungsteils (21) erstreckt.

6. Strombegrenzereinrichtung (1) nach einem der Ansprüche 4 oder 5, bei welcher das erste Leiterelement (31) und das zweite Leiterelement (32) miteinander verlötet sind.

7. Strombegrenzereinrichtung (1) nach einem der vorhergehenden Ansprüche, bei welcher das erste Leiterelement (31) aus Kupfer oder einer kupferhaltigen Legierung gebildet ist.

8. Strombegrenzereinrichtung (1) nach einem der vorhergehenden Ansprüche, bei welcher das zweite Leiterelement (32) einen supraleitenden Bandleiter (61), insbesondere mit einer supraleitenden Schicht auf einem bandförmigen Substrat aufweist.

9. Strombegrenzereinrichtung (1) nach einem der vorhergehenden Ansprüche, bei welcher das zweite Leiterelement (32) ein hochtemperatursupraleitendes Material umfasst.

10. Strombegrenzereinrichtung (1) nach einem der vorhergehenden Ansprüche, bei welcher das zweite Leiterelement (32) mehrere supraleitende Teilleiter (61) aufweist.

11. Strombegrenzereinrichtung (1) nach einem der vorhergehenden Ansprüche, bei welcher der Kryostat (5) als Badkryostat zur Befüllung mit einem flüssigen kryogenen Kühlmittel (41) ausgebildet ist.

12. Strombegrenzereinrichtung (1) nach Anspruch 11, bei welcher der Badkryostat (5) für eine Füllhöhe (47) ausgelegt ist, die so gewählt ist, dass beim Betrieb der Strombegrenzereinrichtung (1) der erste Leitungsteil (21) zu wenigstens 50 % in das flüssige Kühlmittel (41) eingetaucht ist.

13. Strombegrenzereinrichtung (1) nach einem der vorhergehenden Ansprüche, welche einen Kaltkopf (51) umfasst, der im Bereich einer Außenwand des Kryostaten (5) angeordnet ist.

14. Strombegrenzereinrichtung (1) nach einem der vorhergehenden Ansprüche, welche wenigstens zwei Stromzuführungen (7a,7b) umfasst.

## Claims

1. Current limiter device (1) having
- a superconducting coil element (3),
- a cryostat (5) within which the superconducting coil element (3) is arranged,
- at least one current supply line (7a, 7b) for connecting the superconducting coil element (3) to an external circuit
- and at least one feedthrough (11) through an outer wall of the cryostat (5) and through which the current supply line (7a, 7b) is fed,
- wherein the current supply line (7a, 7b) comprises at least one first line part (21) which extends between the feedthrough (11) and the superconducting coil element (3),
- wherein the first line part (21) has at least one first conductor element (31) and one second conductor element (32),
- wherein the first conductor element (31) is designed as a normally conducting metallic conductor element and the second conductor element (32) is designed as a superconducting conductor element connected in parallel therewith,
- **characterized in that** the first conductor element (31) is formed as a conductor element having a cross-sectional area of at least 10 mm².

2. Current limiter device (1) according to Claim 1, in which the current supply line (7a, 7b) has an additional second line part (22) which is normally conducting and which is electrically connected in series with the first line part (21) .

3. Current limiter device (1) according to Claim 1 or 2, in which the first line part (21) extends over a predominant part of the path length (1) between the feedthrough (11) and the superconducting coil element (3).

4. Current limiter device (1) according to one of the preceding claims, in which the first conductor element (31) and the second conductor element (32) are areally connected to one another within the first line part (21).

5. Current limiter device (1) according to Claim 4, in which the areal connection between the first conductor element (31) and the second conductor element (32) extends over the entire length (121) of the first line part (21).

6. Current limiter device (1) according to either of Claims 4 and 5, in which the first conductor element (31) and the second conductor element (32) are soldered to one another.

7. Current limiter device (1) according to one of the preceding claims, in which the first conductor element (31) is formed from copper or a copper-containing alloy.

8. Current limiter device (1) according to one of the preceding claims, in which the second conductor element (32) has a superconducting strip conductor (61), in particular having a superconducting layer on a strip-shaped substrate.

9. Current limiter device (1) according to one of the preceding claims, in which the second conductor element (32) comprises a high-temperature superconducting material.

10. Current limiter device (1) according to one of the preceding claims, in which the second conductor element (32) has a plurality of superconducting sub-conductors (61).

11. Current limiter device (1) according to one of the preceding claims, in which the cryostat (5) is designed as a bath cryostat that is to be filled with a liquid cryogenic cooling medium (41).

12. Current limiter device (1) according to Claim 11, in which the bath cryostat (5) is configured for a filling level (47) which is chosen such that, during operation of the current limiter device (1), at least 50% of the first line part (21) is immersed in the liquid cooling medium (41).

13. Current limiter device (1) according to one of the preceding claims, which comprises a cold head (51) arranged in the region of an outer wall of the cryostat (5).

14. Current limiter device (1) according to one of the preceding claims, which comprises at least two current supply lines (7a, 7b).

## Revendications

1. Limiteur (1) de courant comprenant
- un élément (3) de bobine supraconducteur,
- un cryostat (5) à l'intérieur duquel l'élément (3) de bobine supraconducteur est disposé,
- au moins une arrivée (7a, 7b) de courant pour relier l'élément (3) de bobine supraconducteur à un circuit extérieur,
- et au moins une traversée (11) dans une paroi extérieure du cryostat (5), dans laquelle passe l'arrivée (7a, 7b) de courant,
- dans lequel l'arrivée (7a, 7b) de courant comprend au moins une première partie (21) de ligne, qui s'étend entre la traversée (11) et l'élément (3) de bobine supraconducteur,
- dans lequel la première partie (21) de ligne a au moins un premier élément (31) conducteur et un deuxième élément (32) conducteur,
- dans lequel le premier élément (31) conducteur est constitué sous la forme d'un élément conducteur métallique à conduction normale et le deuxième élément (32) conducteur est constitué sous la forme d'un élément conducteur supraconducteur monté en parallèle,
- **caractérisé en ce que** le premier élément (31) conducteur est constitué sous la forme d'un élément conducteur ayant une surface de section transversale de moins de 10 mm².

2. Limiteur (1) de courant suivant la revendication 1, dans lequel l'arrivée (7a, 7b) de courant a une deuxième partie (22) de ligne supplémentaire, qui est à conduction normale et qui est montée électriquement en série avec la première partie (21) de ligne.

3. Limiteur (1) de courant suivant la revendication 1 ou 2, dans lequel la première partie (21) de la ligne s'étend sur une partie prépondérante de la longueur (1) du chemin entre la traversée (11) et l'élément (3) de bobine supraconducteur.

4. Limiteur (1) de courant suivant l'une des revendications précédentes, dans lequel, à l'intérieur de la première partie (21) de ligne, le premier élément (31) conducteur et le deuxième élément (32) conducteur sont reliés l'un à l'autre en surface.

5. Limiteur (1) de courant suivant la revendication 4, dans lequel la liaison en surface entre le premier élément (31) conducteur et le deuxième élément (32) conducteur s'étend sur toute la longueur (121) de la première partie (21) de la ligne.

6. Limiteur (1) de courant suivant l'une des revendications 4 ou 5, dans lequel le premier élément (31) conducteur et le deuxième élément (32) conducteur sont brasés l'un à l'autre.

7. Limiteur (1) de courant suivant l'une des revendications précédentes, dans lequel le premier élément (31) conducteur est en cuivre ou en un alliage contenant du cuivre.

8. Limiteur (1) de courant suivant l'une des revendications précédentes, dans lequel le deuxième élément (32) conducteur a un conducteur (61) à ruban supraconducteur, ayant notamment une couche supraconductrice sur un substrat en forme de ruban.

9. Limiteur (1) de courant suivant l'une des revendications précédentes, dans lequel le deuxième élément (32) conducteur comprend un matériau supraconducteur à haute température.

10. Limiteur (1) de courant suivant l'une des revendications précédentes, dans lequel le deuxième élément (32) conducteur a plusieurs conducteurs (61) partiels supraconducteurs.

11. Limiteur (1) de courant suivant l'une des revendications précédentes, dans lequel le cryostat (5) est constitué sous la forme d'un cryostat à bain à remplir d'un fluide (41) réfrigérant cryogène liquide.

12. Limiteur (1) de courant suivant la revendication 11, dans lequel le cryostat (5) à bain est conçu pour un niveau (47) de remplissage, qui est choisi de manière à ce que, lors du fonctionnement du limiteur (1) de courant, la première partie (21) de la ligne plonge pour au moins 50% dans le fluide (41) réfrigérant liquide.

13. Limiteur (1) de courant suivant l'une des revendications précédentes, qui comprend une tête (51) froide, qui est disposée dans la région d'une paroi extérieure du cryostat (5).

14. Limiteur (1) de courant suivant l'une des revendications précédentes, qui comprend au moins deux arrivées (7a, 7b) de courant.
